(19) Europäisches Patentamt

European Patent Office

Office européen des brevets

(11) **EP 1 393 450 B1**

(12) **FASCICULE DE BREVET EUROPEEN**

(45) Date de publication et mention
de la délivrance du brevet:
**11.05.2005 Bulletin 2005/19**

(21) Numéro de dépôt: **01993978.4**

(22) Date de dépôt: **07.11.2001**

(51) Int Cl.⁷: **H03M 5/00**, G06F 13/40,
H04L 29/06

(86) Numéro de dépôt international:
**PCT/FR2001/003447**

(87) Numéro de publication internationale:
**WO 2002/039589 (16.05.2002 Gazette 2002/20)**

(54) **DISPOSITIF DE RECEPTION DE SIGNAUX NUMERIQUES**

EINRICHTUNG ZUM EMPFANGEN DIGITALER SIGNALE

DEVICE FOR RECEIVING DIGITAL SIGNALS

(84) Etats contractants désignés:
**FR GB**

(30) Priorité: **07.11.2000 FR 0014260**

(43) Date de publication de la demande:
**03.03.2004 Bulletin 2004/10**

(73) Titulaire: **Thales**
**75008 Paris (FR)**

(72) Inventeurs:
• **BOIRIN, Stéphane, Thales Intellectual property**
**F-94117 Arcueil Cedex (FR)**

• **COULEAUD, Jean-Yves, Thales Intellectual**
**Property**
**F-94117 Arcueil Cedex (FR)**

(74) Mandataire: **Collet, Alain**
**THALES Intellectual Property**
**31-33 avenue Aristide Briand**
**94117 Arcueil Cedex (FR)**

(56) Documents cités:
**EP-A- 0 451 897**        **EP-A- 0 807 888**
**US-A- 4 280 221**        **US-A- 4 860 009**
**US-A- 5 198 700**

**Description**

L'invention se rapporte à un dispositif de réception de signaux numériques essentiellement utilisé dans le transfert de données entre différents équipements embarqués à bord d'un aéronef. Le « Airlines Electronic Engineering Commitee » situé aux Etats-Unis a défini plusieurs normes de transmission de données numériques connues sous le nom de normes ARINC (Aeronautical Radio Incorporation).

Couramment, plusieurs de ces normes sont utilisées dans un même aéronef et nécessitent autant de supports physiques différents que de normes utilisées. La demande de brevet européen EP-A-0 807 888 donne un exemple d'équipement d'aéronef utilisant plusieurs normes. L'invention a pour but de réduire le nombre de supports physiques en permettant la réception de données transitant sur un seul support selon deux normes différentes par exemple les normes ARINC 429 et ARINC 568. On peut se procurer les détails de ces normes auprès de l'Aeronautical Radio Incorporation (ARINC) 2251 River Road, ANNAPOLIS, MARILAND 21401 USA.

Pour atteindre ce but, l'invention a pour objet un dispositif de réception de signaux numériques selon deux normes différentes transitant sur un même support, caractérisé en ce qu'il comporte :

- des moyens de conversion de niveaux logiques, recevant les signaux numériques et convertissant leurs niveaux logiques en niveaux logiques selon un standard unique,
- des moyens de réception de signaux codés selon une première norme, signaux issus des moyens de conversion de niveaux logiques,
- des moyens de conversion de signaux codés selon une seconde norme en signaux codés selon la première norme, signaux issus des moyens de conversion de niveaux logiques,
- des moyens de transfert de signaux issus des moyens de conversion de signaux codés selon une seconde norme en signaux codés selon la première norme, vers les moyens de réception lorsqu'on reçoit des signaux codés selon la seconde norme, ou de signaux issus des moyens de conversion de niveaux logiques lorsqu'on reçoit des signaux codés selon la première norme.

L'invention sera mieux comprise et d'autres avantages apparaîtront à la lecture de la description détaillée d'un mode de réalisation, description illustrée par le dessin joint dans lequel :

- la figure 1 représente sous forme de schéma synoptique un exemple d'un dispositif de réception de signaux numériques conforme à l'invention ;
- les figures 2a, 2b et 2c représentent un exemple de réalisation des moyens de conversion de niveaux logique ;
- les figures 3a, 3b et 3c illustrent un exemple de conversion de signaux codés selon la norme ARINC 568 en signaux codés selon la norme ARINC 429.

Le mode de réalisation décrit ci-dessous fait référence aux normes de codage de signaux numériques ARINC 429 et 568. Il est bien entendu que l'invention peut être mise en oeuvre pour d'autres normes ou pour des standards voisins des deux normes citées dans la mesure où il est possible de convertir un signal codé selon une première norme en un autre signal codé selon la deuxième norme. Il est également possible de mettre en oeuvre l'invention dans un dispositif de réception de signaux numériques susceptible de recevoir des signaux selon plus de deux normes.

La norme ARINC 429 utilise deux conducteurs électriques sous forme de fils torsadés appelés paire torsadée avantageusement entourée d'un écran formant un blindage permettant de se protéger d'éventuelles perturbations électromagnétiques. Sur cette paire circulent en série les signaux codés selon la norme ARINC 429. La tension différentielle entre les conducteurs de la paire définit trois niveaux logiques. Ces données sont organisées sous forme de mots de trente deux bits dont on décrira la structure ultérieurement.

La norme ARINC 568 utilise quant à elle six conducteurs électriques sous forme de trois paires torsadées avantageusement blindées. La tension différentielle entre les deux conducteurs de chacune des paires définit deux niveaux logiques. Sur la première paire, la tension différentielle forme un signal d'horloge oscillant à une fréquence donnée, par exemple à 11 kbits/s entre les deux niveaux logiques. La tension différentielle entre les deux conducteurs de la seconde paire forme un signal de données sous forme de mots de trente deux bits. La tension différentielle entre les deux conducteurs de la troisième paire forme un signal de synchronisation.

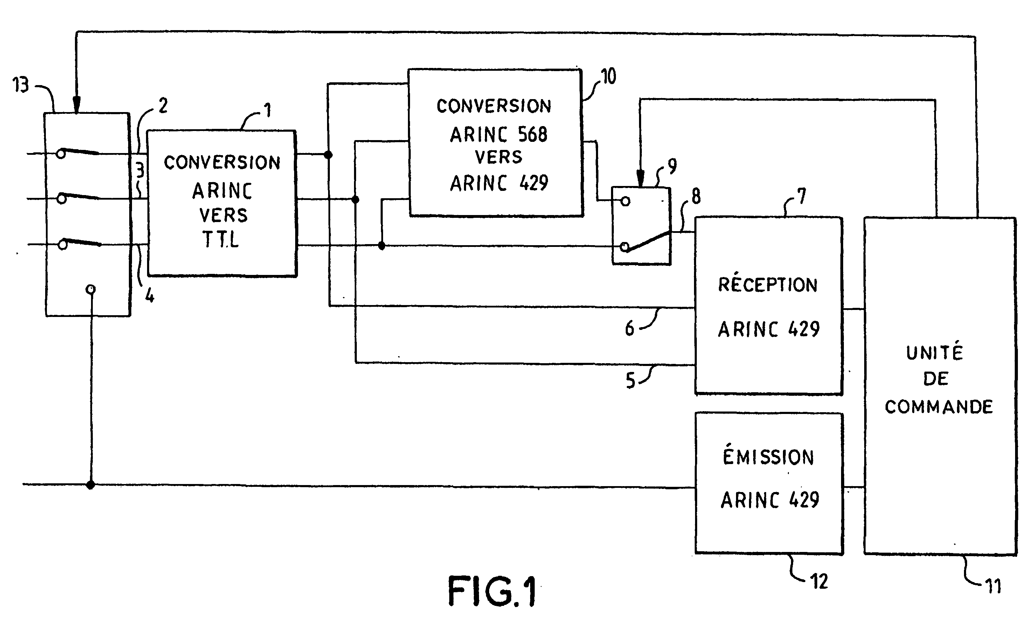

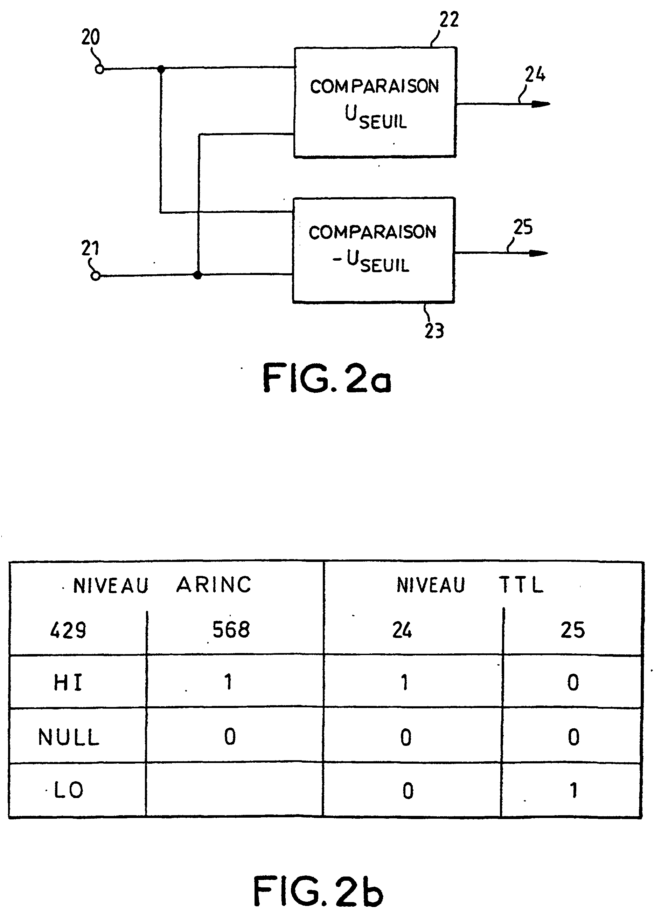

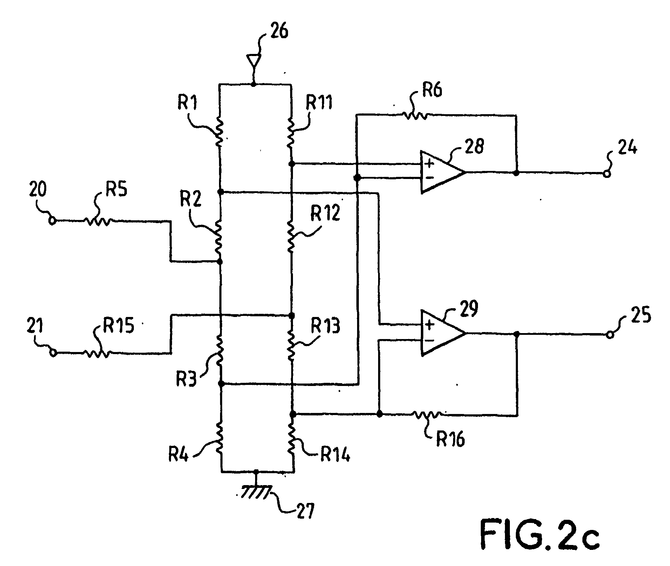

Pour simplifier la représentation de la figure 1, chaque paire est représentée par un trait de liaison. Des moyens de conversion 1 de niveaux logiques reçoivent trois paires sur des entrées 2, 3 et 4. Ces trois entrées peuvent recevoir, soit en parallèle trois séries distinctes de signaux codés selon la norme ARINC 429, soit une série de signaux codés selon la norme ARINC 568. En sortie, les moyens 1 émettent les trois signaux reçus selon l'une ou l'autre des deux normes ARINC 429 ou 568, modifiés de telle sorte qu'ils ne comportent que deux niveaux logiques par exemple selon le standard T.T.L. Ce standard tient son nom (Transistor, Transistor, Logic) d'une technologie utilisant des transistors bipolaires en entrée et en sortie. Selon ce standard, le niveau logique O correspond à une tension inférieure à 0,8 volt et le niveau logique 1 correspond à une tension supérieure à 2,4 volts. La description détaillée des moyens 1 se fera ultérieurement à l'aide des figures 2a, 2b et 2c.

Les trois signaux émis par les moyens 1 sont reçus pour les deux premiers directement sur deux entrées 5 et 6 de moyens de réception 7 de signaux codés selon la norme ARINC 429. Le troisième signal émis par les moyens 1 est reçu sur une entrée 8 des moyens de réception 7 par l'intermédiaire des moyens 9 de transfert de signaux.

Les trois signaux émis par les moyens 1 sont également reçus par des moyens de conversion 10 de signaux codés selon la norme ARINC 568 en signaux codés selon la norme ARINC 429. Les moyens de conversion 10 émettent, vers les moyens 9, un signal codé selon la norme ARINC 429 issu de la conversion de trois signaux codés selon la norme ARINC 568, signaux reçus par les moyens de conversion 10.

Les moyens de transfert 9 reçoivent soit le signal issu des moyens de conversion 10, soit le troisième signal issu des moyens 1 de conversion de niveaux logiques. Les deux signaux pouvant être reçus par les moyens de transfert 9 sont codés selon la norme ARINC 429. Avantageusement, le choix pour les moyens de transfert 9 de recevoir l'un des deux signaux décrits précédemment est réalisé par une unité de commande qui pilote les moyens de transfert 9.

Avantageusement, le dispositif comporte en outre des moyens de test de son fonctionnement. A titre d'exemple, les moyens de test comportent des moyens d'émission 12 de données selon la norme ARINC 429, moyens d'émission 12 pilotés par l'unité de commande 10. Les moyens de test comportent, en outre, des moyens de multiplexage analogique 13 pilotés par l'unité de commande 10. Les moyens 13 sont situés en amont des trois entrées 2, 3 et 4 des moyens 1 de conversion de niveaux logiques.

Lorsque le test de fonctionnement du dispositif n'est pas actif, les moyens de multiplexage 13 transmettent aux entrées 2, 3 et 4 les données codées selon l'une des normes ARINC 429 ou 568 que le dispositif reçoit et les moyens d'émission 12 peuvent servir à émettre des données codées selon la norme ARINC 429 vers un autre équipement électronique de l'aéronef. Par contre, lorsque le test de fonctionnement du dispositif est actif, les moyens de multiplexage ne transmettent plus les données reçues par le dispositif mais transmettent un signal issu des moyens d'émission 12. Ce signal est transmis vers les trois entrées 2, 3 et 4. De plus, les moyens de réception 7 sont reliés à l'unité de commande 11. Ainsi, en émettant un signal au travers des moyens d'émission 12, l'unité de commande 11 peut tester le bon fonctionnement des moyens d'émission 12 des moyens de conversion 1, ainsi que des moyens de réception 7 en comparant le signal émis par les moyens d'émission 12 au signal reçu par les moyens de réception 7.

Les figures 2a, 2b et 2c permettent de décrire un exemple de réalisation des moyens de conversion 1 de niveaux logiques. La norme ARINC 429 prévoit qu'un signal codé selon cette norme peut prendre trois niveaux logiques. Un premier niveau haut noté : « HI » est défini lorsque la tension différentielle entre les deux conducteurs de la paire est supérieure à 6,5 volts. Un second niveau nul noté « NULL » est défini lorsque cette tension est comprise entre -2,5 volts et + 2,5 volts. Un troisième niveau bas noté « LO » est défini lorsque cette tension est inférieure à - 6,5 volts. En revanche, la norme ARINC 568 ne définit que deux niveaux logiques. Un premier niveau haut noté « 1 » est défini lorsque la tension différentielle est supérieure ou égale à 7 volts et un second niveau bas noté « O » est défini lorsque la tension différentielle est comprise entre - 3 volts et + 3 volts.

La figure 2a représente schématiquement le fonctionnement des moyens 1 de conversion de niveaux logiques pour une des entrées 2, 3 ou 4 des moyens 1. L'entrée considérée reçoit les deux conducteurs d'une paire, chacun à un point 20 et 21. Entre ces deux points, peuvent exister les différents niveaux logiques des deux normes ARINC 429 et 568. La tension différentielle présente entre les points 20 et 21 est comparée simultanément à une première tension $U_{seuil}$ ainsi qu'à une seconde tension - $U_{seuil}$ dont la valeur est avantageusement sensiblement égale à l'opposée de la valeur de la première tension $U_{seuil}$. Ces deux comparaisons sont schématisées par le rectangle 22 pour la comparaison à la tension $U_{seuil}$ et le rectangle 23 pour la comparaison à la tension - $U_{seuil}$. Les sorties 24 et 25 des rectangles 22 et 23 représentent respectivement les résultats des comparaisons à $U_{seuil}$ et à - $U_{seuil}$. Ces sorties prennent un des niveaux logiques du standard T.T.L. Pour le rectangle 22, si la tension différentielle présente entre les points 20 et 21 est supérieure à $U_{seuil}$, la sortie 24 prend le niveau logique 1 et dans le cas contraire, la sortie 24 prend le niveau logique O. De même, pour le rectangle 23, si la tension différentielle présente entre les points 20 et 21 est supérieure à - $U_{seuil}$, la sortie 25 prend un niveau logique O et, dans le cas contraire, la sortie 25 prend un niveau logique 1.

En choisissant une valeur de la tension $U_{seuil}$, comprise entre 3 et 6,5 volts, les moyens 1 de conversion de niveaux logiques peuvent convertir sans équivoque les niveaux logiques de signaux codés selon l'une des normes ARINC 429 ou 568 en niveau logique selon le standard T.T.L. Cette conversion est décrite de façon synthétique dans le tableau représenté à la figure 2b qui comprend deux doubles colonnes. La première double colonne comporte dans sa partie gauche les trois niveaux logiques, un par ligne, de la norme ARINC 429, et, dans sa partie droite, les deux niveaux logiques, sur les deux premières lignes du tableau, de la norme ARINC 568. La deuxième double colonne comporte les niveaux logiques des sorties 24 pour la partie gauche et 25 pour la partie droite. Pour le niveau logique HI, selon la norme ARINC 429 ou 1 selon la norme ARINC 568, présent sur les entrées 20 et 21, correspond un niveau logique 1 sur la sortie 24 et un niveau logique 0 sur la sortie 25 selon le standard T.T.L. Pour le niveau logique NULL, selon la norme ARINC 429 ou 0 selon la norme ARINC 568, présent sur les entrées 20 et 21, correspond un niveau logique 0 sur la sortie 24 et un niveau logique 0 sur la sortie 25 selon le standard T.T.L. Pour le niveau logique LO, selon la norme ARINC 429 présent sur les entrées 20 et 21, correspond un niveau logique 0 sur la sortie 24 et un niveau logique 1 sur la sortie 25 selon le standard T.T. L.

La figure 2c représente un exemple de réalisation des moyens 1 de conversion 1 de niveaux logiques, décrits schématiquement à partir de la figure 2a. Entre une tension d'alimentation continue 26 et une masse 27, sont reliées en série et dans l'ordre, d'une part, quatre résistances R1, R2, R3, R4 et, d'autre part, quatre autres résistances R11, R12, R13 et R14. Le point 20 est relié au point commun des résistances R2 et R3 par l'intermédiaire d'une résistance R5 et le point 21 est relié au point commun des résistances R12 et R13 par l'intermédiaire d'une résistance R15. L'entrée non inverseuse d'un amplificateur opérationnel 28 est reliée au point commun des résistances R11 et R12 et l'entrée inverseuse de ce même amplificateur 28 est reliée au point commun des résistances R3 et R4. De même, l'entrée non inverseuse d'un second amplificateur opérationnel 29 est reliée au point commun des résistances R1 et R2 et l'entrée inverseuse de ce même amplificateur 29 est reliée au point commun des résistances R13 et R14. La sortie de l'amplificateur opérationnel 28 forme la sortie 24 et est reliée à son entrée inverseuse par l'intermédiaire d'une résistance R6. De même, la sortie de l'amplificateur opérationnel 29 forme la sortie 25 et est reliée à son entrée inverseuse par l'intermédiaire d'une résistance R16. Il est avantageux de choisir des valeurs identiques pour les résistances R1 et R11, de même pour les résistances R2 et R12, R3 et R13, R4 et R14, R5 et R15 et pour R6 et R16. Ainsi, La valeur de la tension de seuil $U_{seuil}$ est sensiblement égale à la valeur de l'opposée de la tension de seuil -$U_{seuil}$. La valeur de la tension de seuil $U_{seuil}$ est alors donnée par la formule suivante :

$$U_{seuil} = \frac{2 \times VCC \times R5 \times \left[ 1 + \dfrac{R2}{R5} + \dfrac{R2 - R4}{R3 + R4} \right]}{(R1 \times R2) \times \left[ \dfrac{R1}{R1 + R2} + \dfrac{R4}{R3 + R4} \right]}$$

Dans cette formule, VCC représente la différence de potentiel entre la tension d'alimentation continue 26 et la masse 27. Dans cette formule, on a également pris l'hypothèse que la valeur de la résistance R6 est grande par rapport aux valeurs des autres résistances de telle sorte qu'il est possible de négliger l'effet d'hystérésis apporté par la résistance R6.

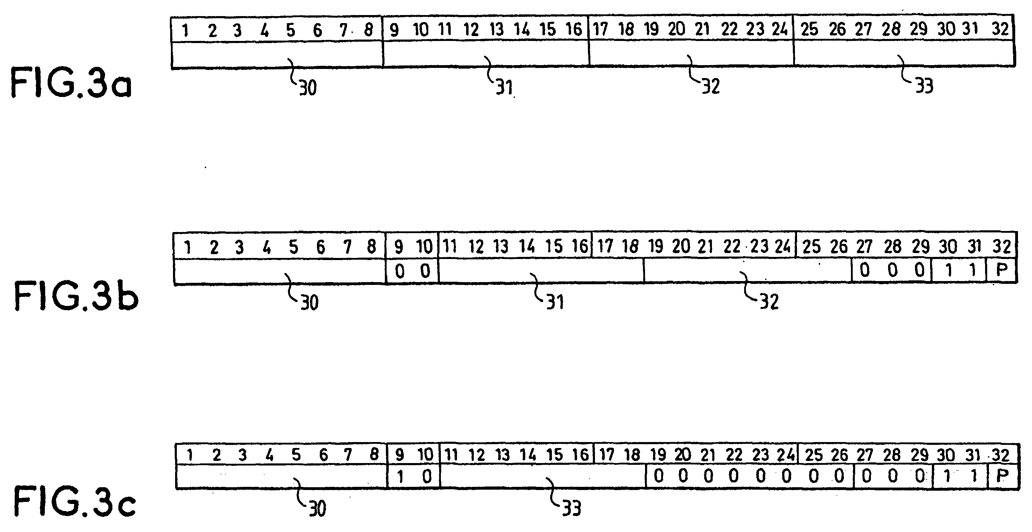

Un exemple de réalisation des moyens de conversion d'un signal codé selon la norme ARINC 568 en un signal codé selon la norme ARINC 429 est illustré au moyen des figures 3a, 3b et 3c. La figure 3a représente un mot de 32 bits codé selon la norme ARINC 568 sur la deuxième paire. Le premier octet de ce mot forme l'étiquette 30 de ce mot et les trois octets suivants, portant dans l'ordre les repères 31, 32 et 33 forment les données du mot. Les moyens 10 de conversion, après avoir reçu ce mot en série, le convertissent en parallèle puis constituent deux mots de 32 bits codés selon la norme ARINC 429, puis convertissent ces deux mots en série pour l'envoyer sur la sortie des moyens 10 de conversion vers les moyens de transfert 9. Les deux mots de 32 bits codés selon la norme ARINC 429 sont représentés figures 3a et 3b.

Le premier octet du mot représenté figure 3b reprend l'étiquette 30. Les deux bits suivants, n° 9 et 10, peuvent, selon la norme ARINC 429, former un identificateur de l'émetteur et du récepteur du signal numérique. Ces deux bits prennent par exemple tous deux un niveau logique O. Les deux octets 31 et 32 de données occupent dans le mot représenté figure 3b, les bits n°11 à 26. Les trois bits suivants, n° 27 à 29, destinés à recevoir des données dans la norme ARINC 429 prennent des niveaux logiques O. Les bits 30 et 31 destinés à recevoir des informations du statut du mot prennent par exemple des niveaux logiques 1. Le dernier bit, n° 32, est le résultat d'un calcul de parité effectué sur les 31 premiers bits du mot.

Le premier octet du mot représenté figure 3c reprend également l'étiquette 30. Les deux bits suivants, n° 9 et 10, prennent par exemple un niveau logique 1 pour le bit n° 9 et O pour le bit n° 10. Ces deux bits forment en d'autres termes une extension de l'étiquette 30 et les niveaux logiques qu'ils prennent figure 3c permettent de différencier ce mot de celui représenté figure 3b où les bits n°9 et 10 prennent tous deux des niveaux logiques 0. L'octet 33 occupe les bits n° 11 à n° 18 du mot représenté figure 3c. Les bits 30 et 31 prennent des niveaux logiques 1 et le dernier bit n° 32 est le résultat d'un calcul de parité effectué sur les 31 premiers bits du mot représenté figure 3c.

La fréquence de transfert des signaux codés selon la norme ARINC 429 peut être de 100 kbits par seconde, fréquence nettement supérieure à celle des signaux codés selon la norme ARINC 568. Cette différence de fréquence permet de transmettre deux mots codés selon la norme ARINC 429 pendant le temps nécessaire à la réception d'un mot codé selon la norme ARINC 568.

Avantageusement, le dispositif peut comporter des moyens pour reconnaître automatiquement la norme reçue. L'unité de commande 11 peut par exemple effectuer cette reconnaissance en testant le niveau logique présent sur la sortie 25. Si ce signal est en permanence au niveau logique O, le signal reçu est codé selon la norme ARINC 568. Dans le cas contraire, le signal est codé selon la norme ARINC 429.

**Revendications**

1. Dispositif de réception de signaux numériques selon deux normes différentes transitant sur un même support (2, 3, 4), **caractérisé en ce qu'**il comporte :

   • des moyens de conversion (1) de niveaux logiques, recevant les signaux numériques et convertissant leurs niveaux logiques en niveaux logiques selon un standard unique.
   • des moyens de réception (7) de signaux codés selon une première norme, signaux issus des moyens de conversion (1) de niveaux logiques,
   • des moyens de conversion (10) de signaux codés selon une seconde norme en signaux codés selon la première norme, signaux issus des moyens de conversion (1 ) de niveaux logiques,
   • des moyens de transfert (9) de signaux issus des moyens de conversion (10) de signaux codés selon une seconde norme en signaux codés selon la première norme, vers les moyens de réception (7) lorsqu'on reçoit des signaux codés selon la seconde norme, ou de signaux issus des moyens de conversion (10) de niveaux logiques lorsqu'on reçoit des signaux codés selon la première norme.

2. Dispositif selon la revendication 1, **caractérisé en ce que** la première norme est la norme ARINC 429 et **en ce que** la seconde norme est la norme ARINC 568.

3. Dispositif selon l'une des revendications précédentes, **caractérisé en ce que** le standard unique est le standard T.T.L

4. Dispositif selon l'une des revendications précédentes, **caractérisé en ce qu'**il comporte en outre des moyens de test (12, 13) de son fonctionnement.

5. Dispositif selon l'une des revendications précédentes, **caractérisé en ce qu'**il comporte en outre des moyens de multiplexage analogique (13) recevant soit les signaux numériques, soit des signaux de sortie issus de moyens d'émission (12) selon la première norme, en fonction d'une commande de test, les moyens de multiplexage (13) transmettant les signaux qu'ils reçoivent au moyen de conversion (1) de niveaux logiques, **en ce qu'**il comporte en outre des moyens de comparaison (11 ) du signal émis par les moyens d'émission (12) au signal reçu par les moyens de réception (7).

6. Dispositif selon l'une des revendications précédentes, **caractérisé en ce que** les signaux sont reçus sous forme d'une tension variable, **en ce que** les moyens de conversion (1) de niveaux logiques comportent des moyens de comparaison (22) de la tension variable à une tension de seuil ($U_{seuil}$) ainsi que des moyens de comparaison (23) de la tension variable à une seconde tension de seuil ( - $U_{seuil}$), **en ce que** le résultat de chaque comparaison prend un des niveaux logiques du standard unique.

7. Dispositif selon la revendication 6, **caractérisé en ce que** la valeur de la tension de seuil ($U_{seuil}$) est sensiblement égale à l'opposée de la valeur de la seconde tension de seuil ( - $U_{seuil}$).

8. Dispositif selon la revendication 7, **caractérisé en ce que** la valeur de la tension de seuil est comprise entre 3 et 6,5 volts.

9. Dispositif selon l'une des revendications 2 à 8, **caractérisé en ce que** les moyens de conversion (10) de signaux codés selon la norme ARINC 568 en signaux codés selon la norme ARINC 429 convertissent un mot de 32 bits codé selon la norme ARINC 568 en deux mots de 32 bits codés selon la norme ARINC 429.

10. Dispositif selon l'une des revendications précédentes, **caractérisé en ce qu'**il comporte en outre des moyens de reconnaissance automatique de la norme selon laquelle les signaux numériques sont codés.

## EP 1 393 450 B1

### Patentansprüche

1. Vorrichtung zum Empfang digitaler Signale gemäß zwei verschiedenen Normen, die über einen gleichen Träger (2, 3, 4) laufen, **dadurch gekennzeichnet, dass** sie Folgendes aufweist:

   - Mittel (1) zur Umwandlung logischer Pegel, die die digitalen Signale empfangen und ihre logischen Pegel in logische Pegel entsprechend einem einzigen Standard umwandeln,
   - Mittel (7) zum Empfang von gemäß einer ersten Norm codierten Signalen, wobei die Signale von den Mitteln (1) zur Umwandlung logischer Pegel stammen,
   - Mittel (10) zur Umwandlung von gemäß einer zweiten Norm codierten Signalen in gemäß der ersten Norm codierte Signale, wobei die Signale von den Mitteln (1) zur Umwandlung logischer Pegel stammen,
   - Mittel (9) zur Übertragung von Signalen, die von den Mitteln (10) zur Umwandlung von gemäß einer zweiten Norm codierten Signalen in gemäß der ersten Norm codierte Signale stammen, zu den Empfangsmitteln (7), wenn gemäß der zweiten Norm codierte Signale empfangen werden, oder von Signalen, die von den Mitteln (10) zur Umwandlung logischer Pegel stammen, wenn gemäß der ersten Norm codierte Signale empfangen werden.

2. Vorrichtung nach Anspruch 1, **dadurch gekennzeichnet, dass** die erste Norm die Norm ARINC 429 und die zweite Norm die Norm ARINC 568 ist.

3. Vorrichtung nach einem der vorhergehenden Ansprüche, **dadurch gekennzeichnet, dass** der einzige Standard der Standard T.T.L. ist.

4. Vorrichtung nach einem der vorhergehenden Ansprüche, **dadurch gekennzeichnet, dass** sie weiter Mittel (12, 13) zum Testen ihres Betriebs aufweist.

5. Vorrichtung nach einem der vorhergehenden Ansprüche, **dadurch gekennzeichnet, dass** sie weiter Mittel zur analogen Multiplexierung (13) aufweist, die in Abhängigkeit von einem Testbefehl entweder die digitalen Signale oder Ausgangssignale empfangen, die von Sendemitteln (12) gemäß der ersten Norm stammen, wobei die Multiplexiermittel (13) die von ihnen empfangenen Signale zum Mittel (1) zur Umwandlung logischer Pegel übertragen, dass sie weiter Mittel (11) zum Vergleich des von den Sendemitteln (12) gesendeten Signals mit dem von den Empfangsmitteln (7) empfangenen Signal aufweist.

6. Vorrichtung nach einem der vorhergehenden Ansprüche, **dadurch gekennzeichnet, dass** die Signale in Form einer variablen Spannung empfangen werden, dass die Mittel (1) zur Umwandlung logischer Pegel Mittel (22) zum Vergleich der variablen Spannung mit einer Schwellenspannung ($U_{seuil}$) sowie Mittel (23) zum vergleich der variablen Spannung mit einer zweiten Schwellenspannung ($-U_{seuil}$) aufweisen, dass das Ergebnis jedes Vergleichs einen der logischen Pegel des einzigen Standards annimmt.

7. Vorrichtung nach Anspruch 6, **dadurch gekennzeichnet, dass** der Wert der Schwellenspannung ($U_{seuil}$) im Wesentlichen gleich dem Gegenteil des Werts der zweiten Schwellenspannung ($-U_{seuil}$) ist.

8. Vorrichtung nach Anspruch 7, **dadurch gekennzeichnet, dass** der Wert der Schwellenspannung zwischen 3 und 6,5 Volt liegt.

9. Vorrichtung nach einem der Ansprüche 2 bis 8, **dadurch gekennzeichnet, dass** die Mittel (10) zur Umwandlung von gemäß der Norm ARINC 568 codierten Signalen in gemäß der Norm ARINC 429 codierte Signale ein gemäß der Norm ARINC 568 codiertes Wort von 32 Bits in zwei gemäß der Norm ARINC 429 codierte Wörter von 32 Bits umwandeln.

10. Vorrichtung nach einem der vorhergehenden Ansprüche, **dadurch gekennzeichnet, dass** sie außerdem Mittel zur automatischen Erkennung der Norm aufweist, gemäß der die digitalen Signale codiert sind.

### Claims

1. Device for receiving digital signals on the basis of two different standards conveyed on the same medium (2, 3, 4), **characterized in that** it comprises:

- logic-level conversion means (1) receiving the digital signals and converting their logic levels into logic levels on the basis of a single standard,
- means (7) for receiving signals coded on the basis of a first standard, which signals are output by the logic-level conversion means (1),
- means (10) for converting signals coded on the basis of a second standard into signals coded on the basis of the first standard, which signals are output by the logic-level conversion means (1),
- means (9) for transferring signals output by the means (10) for converting signals coded on the basis of a second standard into signals coded on the basis of the first standard to the reception means (7) upon reception of signals coded on the basis of the second standard, or for transferring signals output by the logic-level conversion means (1) upon reception of signals coded on the basis of the first standard.

2. Device according to Claim 1, **characterized in that** the first standard is the ARINC 429 standard and **in that** the second standard is the ARINC 568 standard.

3. Device according to one of the preceding claims, **characterized in that** the single standard is the T.T.L. standard.

4. Device according to one of the preceding claims, **characterized in that** it also comprises means (12, 13) for testing its operation.

5. The device according to one of the preceding claims, **characterized in that** it also comprises analogue multiplexing means (13) receiving either the digital signals or output signals which are output by transmission means (12) on the basis of the first standard, depending on a test command, the multiplexing means (13) transmitting the signals they receive by means of logic-level conversion (1), and **in that** it also comprises means (11) for comparing the signal transmitted by the transmission means (12) with the signal received by the reception means (7).

6. Device according to one of the preceding claims, **characterized in that** the signals are received in the form of a variable voltage, **in that** the logic-level conversion means (1) comprise means (22) for comparing the variable voltage with a threshold voltage ($U_{thresh}$) and means (23) for comparing the variable voltage with a second threshold voltage ($-U_{thresh}$), and **in that** the result of each comparison takes one of the logic levels from the single standard.

7. Device according to claim 6, **characterized in that** the value of the threshold voltage ($U_{thresh}$) is more or less equal to the opposite of the value of the second threshold voltage ($-U_{thresh}$).

8. Device according to Claim 7, **characterized in that** the value of the threshold voltage is between 3 and 6.5 volts.

9. Device according to one of Claims 2 to 8, **characterized in that** the means (10) for converting signals coded on the basis of the ARINC 568 standard into signals coded on the basis of the ARINC 429 standard convert a 32-bit word coded on the basis of the ARINC 568 standard into two 32-bit words coded on the basis of the ARINC 429 standard.

10. Device according to one of the preceding claims, **characterized in that** it also comprises means for automatically recognizing the standard on the basis of which the digital signals have been coded.

FIG.1

EP 1 393 450 B1

FIG. 2a

| NIVEAU ARINC | | NIVEAU TTL | |
|---|---|---|---|
| 429 | 568 | 24 | 25 |
| HI | 1 | 1 | 0 |
| NULL | 0 | 0 | 0 |
| LO | | 0 | 1 |

FIG. 2b

FIG.2c

**FIG.3a**

| 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | 30 | 31 | 32 |
|---|---|---|---|---|---|---|---|---|----|----|----|----|----|----|----|----|----|----|----|----|----|----|----|----|----|----|----|----|----|----|----|
|   |   |   |   |   |   |   |   |   |    |    |    |    |    |    |    |    |    |    |    |    |    |    |    |    |    |    |    |    |    |    |    |

30     31     32     33

**FIG.3b**

| 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | 30 | 31 | 32 |
|---|---|---|---|---|---|---|---|---|----|----|----|----|----|----|----|----|----|----|----|----|----|----|----|----|----|----|----|----|----|----|----|
|   |   |   |   |   |   |   |   | 0 | 0  |    |    |    |    |    |    |    |    |    |    |    |    |    |    |    |    | 0  | 0  | 0  | 1  | 1  | P  |

30     31     32

**FIG.3c**

| 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | 30 | 31 | 32 |
|---|---|---|---|---|---|---|---|---|----|----|----|----|----|----|----|----|----|----|----|----|----|----|----|----|----|----|----|----|----|----|----|
|   |   |   |   |   |   |   |   | 1 | 0  |    |    |    |    |    |    |    |    | 0  | 0  | 0  | 0  | 0  | 0  | 0  | 0  | 0  | 0  | 0  | 1  | 1  | P  |

30     33